# EUROPÄISCHE PATENTSCHRIFT

(11) **EP 1 252 961 B1**
(45) Veröffentlichungstag und Bekanntmachung des Hinweises auf die Patenterteilung: **13.10.2004**
(21) Anmeldenummer: 02405198.9
(22) Anmeldetag: 15.03.2002
(51) Int. Cl.: B23K 3/08, H05K 3/34

(54) **Variable Lötmaske**
Modifiable brazing mask
Masque de brasage modifiable

(30) Priorität: 03.04.2001 CH 6282001
(43) Veröffentlichungstag der Anmeldung: 30.10.2002
(73) Patentinhaber: Techni Print, 5106 Veltheim (CH)
(72) Erfinder: Lüthi, Christian, 5106 Veltheim (CH)
(74) Vertreter: Patentanwälte Feldmann & Partner AG

(56) Entgegenhaltungen:
- WO-A-00/59670
- DE-A- 19 950 843
- US-A- 5 820 013
- PATENT ABSTRACTS OF JAPAN vol. 2000, no. 09, 13. Oktober 2000 (2000-10-13) & JP 2000 183510 A (OOTEKKU KK), 30. Juni 2000 (2000-06-30)

## Beschreibung

Die Erfindung betrifft eine variable Lötmaske zum automatischen Löten von elektrischen und elektronischen Komponenten auf Leiterplatten nach dem Oberbegriff des Patentanspruchs (siehe, z.B. WO-A-00/59670).

Bestückungs- oder Lötrahmen zum automatischen Löten von elektrischen und elektronischen Komponenten auf Leiterplatten sind beispielsweise aus DE-U-93 16 126.3 bekannt. Solche Lötrahmen werden zum Wellenlöten in handelsüblichen Lötstrassen eingesetzt, in denen die Lötrahmen von Kettenförderern oder Rollen geführt sind. Es besteht dabei das Problem, dass einzelne über die Leiterplatte hinausragende Komponenten wie Steckanschlüsse, Schalter oder dergleichen eine optimale Befestigung der Leiterplatte im zu einer bestimmten Lötstrasse gehörenden Lötrahmen behindern. Eine zu verlötende Platine muss zuerst in einem separaten Arbeitsgang mit der benötigten Lötmaske versehen werden, worauf sie erst in den Lötrahmen eingesetzt werden kann.

In WO 00/59670 wird ein ähnlicher, aber variabler Lötrahmen zum maschinellen Löten von elektronischen und elektrischen Komponenten auf Leiterplatten beschrieben, mit mindestens zwei sich gegenüberliegenden Stegen, die Klemmelemente zum Einspannen der Leiterplatten vorweisen. In der Umrandung des Bestückungsrahmens sind Längsführungen vorgesehen, in welchen zumindest ein verschiebbarer Steg geführt ist, der mittels Befestigungsmittel fixierbar ist, um Leiterplatten von unterschiedlichen Ausmassen aufzunehmen. An der Fixierung mit dem verschiebbaren Quersteg zur Abstützung befindet sich immer eine Fläche, an welcher die Platine nicht abgedeckt ist. Hier kann beim Wellenlöten die Welle überschwappen und auf die Oberseite der Platine gelangen. Auch hier muss eine zu verlötende Platine zuerst in einem separaten Arbeitsgang mit der benötigten Lötmaske versehen werden, worauf sie erst in den Lötrahmen eingesetzt werden kann.

Um bestimmte Stellen auf den zu verlötenden Platinen abzudecken, an welchen keine Verlötung stattfinden darf, wie beispielsweise Montagelöcher, bestimmte elektronische Bauteile, welche an der Unterseite der Platine angeordnet sind, werden daher spezielle Lötmasken für eine jeweilige Leiterplatte hergestellt. Sie werden mit der Platine verbunden gemeinsam in einen Lötrahmen eingesetzt. Der Ein- und Ausbau der Lötmaske in einen - Lötrahmen bietet vielfach Probleme. Der Lötrahmen zur Aufnahme einer Platine mit zugehörender Lötmaske muss dabei für jede spezifische Leiterplatte einzeln hergestellt werden. Wenn sie in einem variablen Lötrahmen eingesetzt sind, welcher zur Aufnahme von verschiedenen Platinen geeignet ist, so bleiben immer auf mindestens einer Seite offene Bereiche zwischen Platine und Lötrahmen bestehen. Beim Wellenlöten schwappt die Lotwelle an diesen offenen Bereichen um den Platinenrand und gelangt oft sogar auf die Oberseite der Platine. Solche Platinen sind nicht brauchbar und gelangen in den Ausschuss. Dies ist ganz besonders der Fall, wenn im Lötsystem mit einer zusätzlichen sogenannten Chipwelle, welche zur Verhinderung eines Lötschattens dient, gearbeitet wird. Der Einsatz der Chipwelle im Lötsystem ist notwendig, wenn SMD Bauteile auf der Unterseite der Platine angeordnet mitverlötet werden müssen.

Der vorliegenden Erfindung liegt nun die Aufgabe zugrunde, eine variable Lötmaske zu entwickeln, die für verschiedenartige Leiterplatten universell einsetzbar ist und ein schneller Austausch der Leiterplatten ermöglicht und dabei die genannten Nachteile im Zusammenhang der Lötmaske mit dem Lötrahmen überwindet.

Diese Aufgabe wird durch eine Lötmaske mit den Merkmalen des Patentanspruchs 1 gelöst.

Die erfindungsgemässe Lötmaske hat den grossen Vorteil, dass sie für fast jede beliebige Leiterplatte mit einer beliebigen Bestückung der elektrischen und elektronischen Komponenten geeignet ist. Ein verschiebbarer Steg kombiniert mit den variablen Abdeckungen als Lötmaskenelemente erlaubt die individuelle Anpassung der Lötmaske samt Rahmen und Halterung auf die Ausmasse der jeweiligen Leiterplatte und der jeweiligen Bestückung insbesondere auf der Unterseite.

Eine weiterer Vorteil der erfindungsgemässen Lötmaske besteht darin, dass besonders für spezielle Prints in kleinen Stückzahlen keine individuelle lötmaske hergestellt werden muss. Einzelne Prototypen von Platinen können damit auf kostengünstigste Weise zum Wellenlöten vorbereitet werden.

Die Erfindung wird nun anhand der Figuren näher erläutert.

Es zeigt
- Fig. 1: einen erfindungsgemässen Lötrahmen in perspektivischer Darstellung gemäss Stand der Technik,
- Fig. 2: einen justierbaren Niederhalter gemäss Stand der Technik,
- Fig. 3: eine perspektivische Ansicht einer einstellbaren Randabdeckung im Zustand vor der Anlage an die Platine,
- Fig. 4: eine perspektivische Ansicht einer einstellbaren Randabdeckung im Zustand in Anlage an der Platine,
- Fig. 5: einen Querschnitt einer anderen Ausführung der einstellbaren Randabdeckung,
- Fig. 6: gleiche Ansicht mit zusätzlichem verschiebbarem Lötmaskenelement,
- Fig. 7: zwei gegenüberliegende Lötrahmenstege mit einstellbaren Trägem für ein Lötmaskenelement in Seitenansicht,
- Fig. 8: ditto in Aufsicht,
- Figuren 9a und 9b: weitere Ausführungsformen von Lötmaskenelementen.

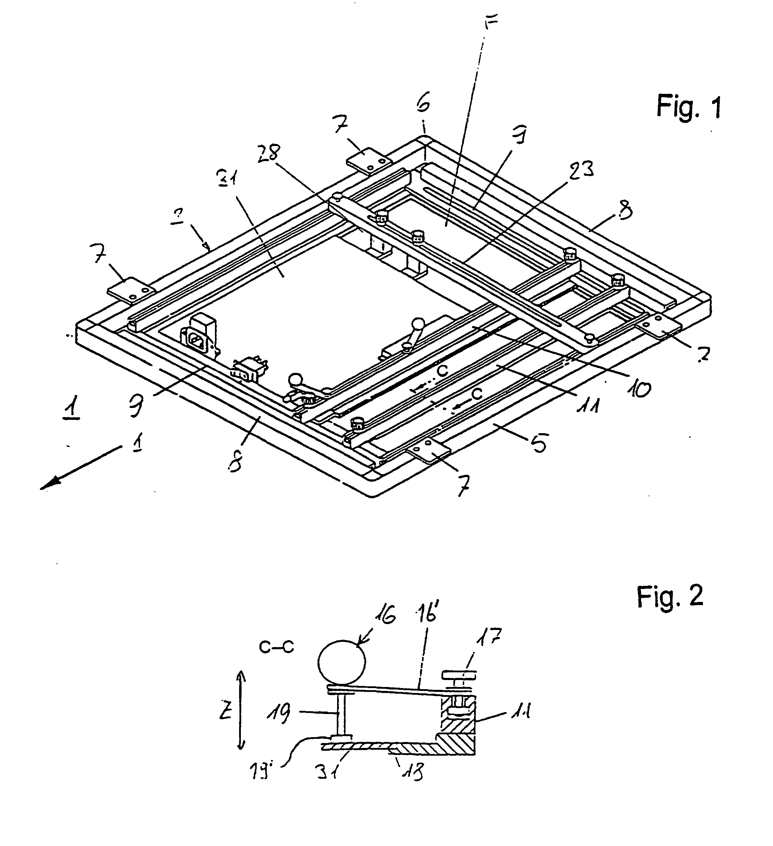

In Figur 1 ist ein viereckiger Lötrahmen 1 gezeigt, der eine äussere Umrandung 2 und eine innere Auflage 3 mit einem nach innen abgestuften Rand 4 aufweist. Die äussere Umrandung 2 ist auf den zwei Längsseiten 5 im Bereich der Ecken 6 je mit einer Auflage 7 versehen, die für einen - hier nicht weiter dargestellten- Kettenförderer vorgesehen sind. Die äussere Umrandung 2 mit den Auflagen 7 ist Teil eines Original-Lötrahmens, wie er für eine Schwalllöteinrichtung vom Hersteller mitgeliefert wird. Parallel zu den Querseiten 8 des Lötrahmens 1 auf der inneren Auflage 3 sind zwei als Schlitze ausgebildete Längsführungen 9 angeordnet, in welchen zwei verschiebbare, mit einer Nut 12 versehene Stege 10 und 11 mittels Rändelschrauben 14 an einer bestimmten Stelle auf dem Rahmen 1 befestigt werden können. Auf dem verschiebbaren Steg 10 sind ferner zwei als Federspanner ausgebildete Niederhaltemittel 16 mit variabler Spannhöhe angeordnet, welche in der Nut 12 verschiebbar und mittels einer Rändelschraube 17 fixierbar sind. Die Stege 10 und 11 sind zur Bildung der Nut 12 mit einem U-förmigen Profilstab ausgebildet.

Parallel zu den Längsseiten 5 zwischen der Umrandung 2 und der inneren Auflage 3 des Lötrahmens 1 sind jeweils zwei mit einer Nut 22 versehene feste Stege 20 und 21 angeordnet, auf welchen ein Quersteg 23 verschiebbar und mittels Rändelschrauben 24 darauf fixierbar ist. Der verschiebbare Quersteg 23 weist ferner einen Schlitz 26 auf, in welchem zwei weitere Stützelemente 28 verschiebbar und mittels Rändelschrauben 29 darauf fixierbar sind. Die Stützelemente 28 sind mit unten vorstehenden, gestuften Stützelementen 30 versehen. Gut ersichtlich ist, dass konstruktionsbedingt zwischen einer zu verlötenden Platine und dem Lötrahmen eine Fläche F offen und unabgedeckt bestehen bleibt. Es ist offensichtlich, dass hier die Lötwelle auf die Oberseite der Platine überschwappen kann. Beim Einsatz einer Chipwelle beim Löten wird hier die Platine zerstört.

Die Niederhalter 16 gemäss Figur 2 können mittels den Rändelschrauben 17 im verschiebbaren Steg 11 in einer Richtung X parallel zum Steg verschoben und am geeigneten Ort arretiert werden. Zum Zweiten weisen die Niederhaltemittel 16 einen Arm 16' auf, welcher mittels der Rändelschraube 17 am Steg 10 arretierbar ist. Und sie weisen je ein Bein 19 auf, welches am der Rändelschraube 17 gegenüberliegenden Ende des Armes angeordnet ist und dadurch immer von der Rändelschraube und dem Steg 10 beabstandet ist. Der Arm 16' ist möglichst als Schwenkarm um die Rändelschraube 17 schwenkbar ausgestaltet. Somit kann das Bein 19, welches auf der Leiterplatte zum Aufliegen kommt in X und Y Richtung auf einer radialen Bahn um die Rändelschraube 17 bewegt werden. Das Bein 19 kann so auf eine möglichst geeignete Stelle der Leiterplatte aufgelegt werden. Die dritte verstellbare Dimension kommt durch Aendern der Länge des Beines 19 zustande. Damit ist aber erst ein Lötrahmen gemäss Stand der Technik vorhanden, welcher keinerlei Funktionalität für eine Lötmaske aufweist.

Um nun die Eigenschaften einer Lötmaske zu erhalten und deren Funktionen tatsächlich erfüllen zu können, müssen nun verschiedene Bedingungen erfüllt werden. Insbesondere soll ja eine möglichst variable und variabel einsetzbare Lötmaske geschaffen werden.

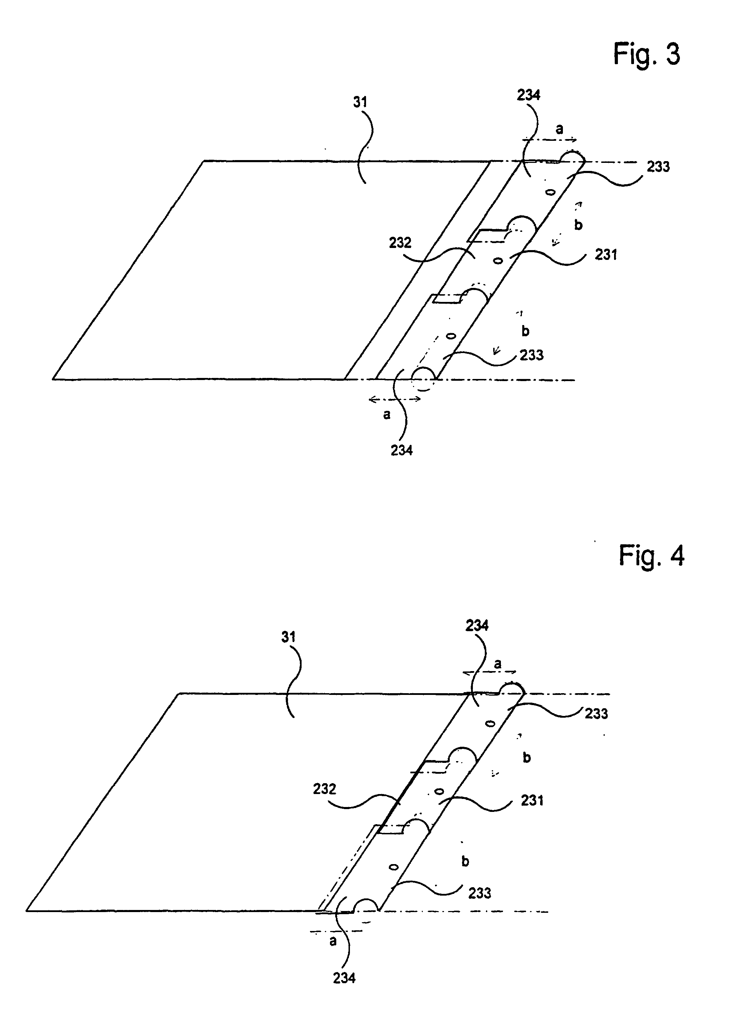

Zuerst wird nun auf das Verhindern des Ueberschwappens der Lötwelle, insbesondere der Chipwelle, eingegangen. Dies ermöglicht erst, eine Lötmaske variabel und anpassbar zu machen, so dass sie nicht separat vom Lötrahmen vormontiert werden muss. Dies wird durch eine verschiebbare und anpassbare Abdeckung der Fläche zwischen Lötrahmen und Platine erreicht. Eine erste Ausführungsform einer solchen verschiebbaren Abdeckung 232, 234 ist in Figur 3, beim Einlegen einer Platine, und Figur 4, bei lötbereit eingelegter Platine, dargestellt. Am in Richtung a verschiebbaren Steg 23 (gemäss dem Lötrahmen nach Figur 1), welcher hier der Einfachheit halber als runder Stab angedeutet ist, ist mindestens eine verschiebbare Abdeckung 232, 234 seitlich verschiebbar in Richtung b und arretierbar im Steg 23 befestigt. Zwei der hier gezeigten verschiebbaren Abdeckungen 234 untergreifen den Rand der Platine ganz wenig. Die Platine liegt somit mit ihrem Rand auf diesen Abdeckungen 234 leicht auf. Eine dritte verschiebbare Abdeckung 232 ist so angeordnet, dass sie genau am Platinenrand zum Anliegen kommt. Die ersten beiden Abdeckungen 234 können mindestens teilweise unter die dritte Abdeckung 232 geschoben werden, um auch an eine schmälere Platine angepasst zu werden. Dadurch kann annähernd jede Platine eingespannt werden, wobei die Fläche zwischen ihr und dem Steg 23 abdeckbar ist. In der dargestellten Ausführung umfassen die verschiebbaren Abdeckungen 232, 234 den Steg 23 teilweise von oben. Sie können so in den Richtungen b gegeneinander verschoben und in der gewünschten Position beispielsweise mit einer Schraube fixiert werden. Eine eingelegte Platine ist nun am Rand vollständig umfangen, respektive abgedeckt, so dass die Lötwelle und insbesondere die Chipwelle nicht mehr um den Platinenrand schwappen können.

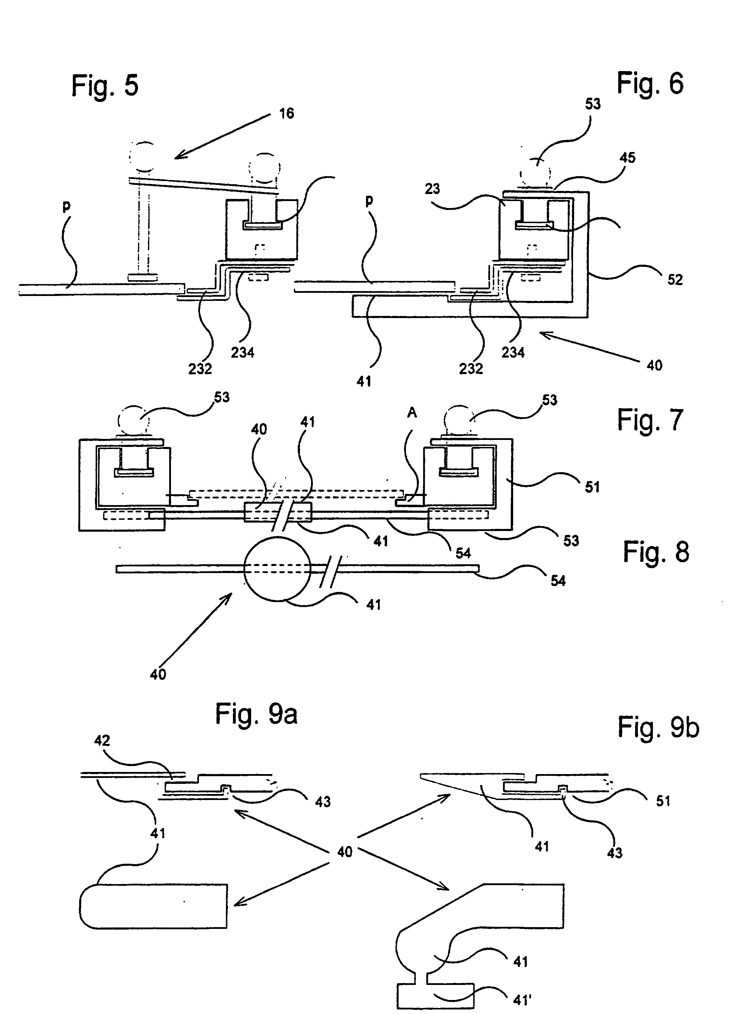

Bei einer Ausführungsform nach Figur 5 sind die verschiebbaren Abdeckungen 232, 234 an der Unterseite eines festen oder verschiebbaren Steges 23 gegeneinander verschiebbar und anpassbar angeordnet. Aus dem Schnittbild der Figur 5 ist ersichtlich, wie die Abdeckungen 232 den Bereich zwischen dem Steg und der Platine abdecken, indem sie am Platinenrand in Anlage kommen. Die verschiebbaren Abdeckungen 234 befinden sich unterhalb der Abdeckung 232 und dienen gleichzeitig als Randauflage für die Platine, welche mit Niederhaltern 16 auf den Randauflagen gehalten wird.

In der Figur 6 ist die gleiche Ansicht dargestellt, aber mit einem Lötmaskenelement 40 ergänzt. Das Lötmaskenelement 40 umfasst eine Abdeckfläche 41, welche die Funktion übernimmt, die Unterseite einer Platine am gewünschten Ort und in gewünschter partieller flächiger Ausdehnung abzudecken, damit hier keine Verlötung stattfinden kann. Die Abdeckfläche befindet sich an einem Halteelement 52, mittels welchem das Lötmaskenelement 40 als ganzes am Steg 23 lösbar befestigt ist. Die Befestigung kann mittels einem Klemmelement 53 oder einer Schraube oder dergleichen am oder im Steg 23 geschehen. Das dargestellte Beispiel eines Lötmaskenelementes ist beispielsweise geeignet zur Abdeckung als Maske für Grundlöcher der Platine. Selbstverständlich kann die Abdeckfläche 41 verschiedene Umrisse aufweisen, so wie die Maske für den einzelnen Fall sein soll. Beispielse sind aus den Figuren 8 und 9 ersichtlich.

In den Figuren 7 und 8 ist ein Lötmaskenelement mit seiner Abdeckfläche 41 an einem Stützstab 54 angebracht. Der Stützstab 54 ist vorzugsweise aus Titan, da dieses nicht durch Lot benetzbar ist. Der Stützstab 54 ist beidseitig in einem Halteelement 51 gefasst. Die Halteelemente 51 sind mittels einem Klemmelement 53 oder einer Schraube oder dergleichen am oder im Steg 23 lösbar befestigt. Der Stützstab 54 dient gleichzeitig auch zur Abstützung der Platine. Dies kann bei fläching grossen Platinen nötig sein. Zusätzlich können solche Stützstäbe verwendet werden als Unterlagstütze für Platinen, welche bereits geritzt sind, um später in einzelne Teilplatinen gebrochen zu werden.

Weitere Formen von Lötmaskenelementen 40 sind in den Figuren 9a und 9b gezeigt. Im Unterschied zu den Beschriebenen sind diese Lötmaskenelemente 40 zur lösbaren Befestigung nicht an einem der Stege, sondern direkt an den Platinenauflagen oder einer der verschiebbaren Abdeckungen 234 ausgestaltet. Dazu weist sie eine U-förmige Klammer 42 auf, welche die Platinenaufnahmen teilweise umfasst, und mit welcher sie daran festgeklemmt hält. Zur Sicherung der Position empfiehlt es sich, die Klammer 42 mit einer Nase 51 zu ergänzen. Die Nase 51 ist zur Aufnahme in einer Nut 51 in der Platinenauflage oder der verschiebbaren Abdeckung 232, 234 vorgesehen. Mit der U-förmigen Klammer 42 und ergänzt mit der Nase 51 kann das Lötmaskenelement 40 exakt positioniert werden und ist anschliessend gesichert gehalten.

Das Lötmaskenelement 40 kann aus relativ dünnem Federblech wie in Figur 9a geformt sein oder als festeres Teil aus geeignetem hitzebeständigem Material wie in Figur 9b ausgestaltet sein. Dass die Abdeckfläche 41 eine verschiedene Umrisse aufweisen kann, ist hier in den Aufsichten anhand von 2 Beispielen dargestellt. Sie kann exakt auf die individuell benötigte Form und Fläche ausgelegt werden und mittels der Klammer 42 auch richtig und präzise montiert werden. Ein Lötmaskenelement kann mit mehreren Abdeckflächen 41, 41' versehen sein, wie dies aus der Figur 9b ersichtlich ist.

## Patentansprüche

1. Lötmaske zum maschinellen Löten von elektronischen und elektrischen Komponenten (32) auf Leiterplatten (31), mit einem Lötrahmen (1) mit mindestens zwei sich gegenüberliegenden Stegen (9), die Klemmelemente zum Einspannen der Leiterplatten (31) vorweisen, mit in der Umrandung (2) des Lötrahmens (1) angeordneten Längsführungen (9), in welchen zumindest ein verschiebbarer Steg (10; 11, 23) geführt und mittels Befestigungsmitteln (14) fixierbar ist, um Leiterplatten (31) von unterschiedlichen Ausmassen aufzunehmen, wobei die Umrandung (2) auf der Innenseite eine Auflage (18) zur Abstützung der Leiterplatte (31) aufweist, welche mindestens teilweise einen nach unten abgestuften Rand (3,4) aufweist, und mit mindestens einem Niederhaltemittel (16), **dadurch gekennzeichnet, dass** mindestens zwei entlang einem der Stege (9,10, 11, 23) verschiebbare Abdeckungen (232, 234) zur Abdeckung eines Spaltes zwischen einer eingelegten zu verlötenden Platine und dem verschiebbaren Steg (10,11,23) vorhanden sind, welche mindestens teilweise als Auflage ausgestaltet sind, wobei mindestens eine der mindestens zwei Abdeckungen mindestens teilweise unter die andere geschoben werden kann.

2. Lötmaske nach Anspruch 1, **dadurch gekennzeichnet, dass** sie Lötmaskenelemente (40) umfasst, welche je mindestens eine Abdeckfläche (41) zur Anlage an der Unterseite einer zu verlötenden Platine aufweisen und dass an der Auflage (18) oder an den Stegen (9,10,11,23) Halteelemente (50, 51, 52) zur Befestigung der Lötmaskenelemente (40) vorhanden sind.

3. Lötmaske nach Anspruch 2, **dadurch gekennzeichnet, dass** das Lötmaskenelement (40) eine Klammer (43) zur teilweisen Umklammerung einer Auflage (18) aufweist.

4. Lötmaske nach Anspruch 3, **dadurch gekennzeichnet, dass** die Klammer (43) eine Nase (42) aufweist, welche in eine Nut (50) in der Auflage (18) als Haltemittel eingreift.

5. Lötmaske nach Anspruch 2, **dadurch gekennzeichnet, dass** das Lötmaskenelement (40) einen Träger (45) als Halteelement (52) aufweist, welcher an einem der Stege (9,10,11,23) befestigbar ist.

6. Lötmaske nach Anspruch 5, **dadurch gekennzeichnet, dass** der Träger (45) mittels einem Arretiermittel (53) an einem der Stege (9,10,11,23) befestigbar ist.

7. Lötmaske nach Anspruch 2, **dadurch gekennzeichnet, dass** das Lötmaskenelement (40) an einem Stützstab (54) befestigt ist und dass der Stützstab (54) an mindestens einem Halteelement (51) befestigt ist, welches mittels einem Arretiermittel (53) an einem der Stege (9,10,11,23) befestigbar ist.

8. Lötmaske nach Anspruch 7, **dadurch gekennzeichnet, dass** der Stützstab (54) an zwei gegenüberliegenden Halteelementen (51) und somit an zwei einander gegenüberliegenden Stegen (9,10,11,23) befestigbar ist.

9. Lötmaske nach Anspruch 7, **dadurch gekennzeichnet, dass** der Stützstab (54) als Unterlagstütze für geritzte Platinen verwendbar ist.

10. Lötmaske nach Anspruch 7, **dadurch gekennzeichnet, dass** der Stützstab (54) Titan enthält.

## Claims

1. A soldering mask for the machined soldering of electronic and electrical components (32) on printed circuit [boards] (31), with a soldering frame (1) with at least two webs (9) which lie opposite one another which comprise clamping elements for clamping in the printed circuit [boards] (31), with longitudinal guides (9) arranged in the edging (2) of the soldering frame (1) in which at least one displaceable web (10; 11, 23) may be guided and may be fixed by way of fastening means (14), in order to accommodate printed circuit [boards] (31) of various dimensions, wherein the edging (2) on the inner side comprise a rest (18) for the support of the printed circuit [board], which at least partly comprises an edge (3, 4) which is stepped downwards, and with at least one holding-down means (16), **characterised in that** there are present at least two covers (232, 234) for covering a gap between an applied board to be soldered and the displaceable web (10, 11, 23), which are displaceable along one of the webs (9, 10, 11, 23) and which at least partly are designed as a rest, wherein at least one of the at least two covers, at least partly, may be pushed below the other one.

2. A soldering mask according to claim 1, **characterised in that** it comprises a soldering mask element (40) which in each case comprise at least one cover surface (41) for bearing on the lower side of a board to be soldered and that retaining elements (50, 51, 52) for fastening the soldering mask elements (40) are present on the rest (18) or on the webs (9, 10, 11, 23).

3. A soldering mask according to claim 2, **characterised in that** the soldering mask element (40) comprises a clip (clamp) (43) for the partial peripheral clamping of a rest (18).

4. A soldering mask according to claim 3, **characterised in that** the clip (clamp) (43) comprises a lug (42) which engages into a groove (50) in the rest (18) as a holding (retaining) means.

5. A soldering mask according to claim 2, **characterised in that** the soldering mask element (40) comprises a carrier (45) as a retaining element (52) which may be fastened on one of the webs (9, 10, 11, 23).

6. A soldering mask according to claim 5, **characterised in that** the carrier (45) may be fastened on one of the webs (9, 10, 11, 23) by way of a locking means (53).

7. A soldering mask according to claim 2, **characterised in that** the soldering mask element (40) is fastened on a support rod (54) and that the support rod (54) is fastened on at least one retaining element (51) which may be fastened on one of the webs (9, 10, 11, 23) by way of a locking means (53).

8. A soldering mask according to claim 7, **characterised in that** the support rod (54) may be fastened on two oppositely lying retaining elements (51) and thus on two oppositely lying webs (9, 10, 11, 23).

9. A soldering mask according to claim 7, **characterised in that** the support rod (54) may be used as an underlay support for notched boards.

10. A soldering mask according to claim 7, **characterised in that** the support rod (54) contains titanium.

## Revendications

1. Masque de brasage pour le brasage mécanique de composantes (32) électroniques et électriques sur des plaquettes (31), avec un cadre de brasage (1) avec au moins deux traverses (9) opposées qui montrent des éléments de serrage pour serrer les plaquettes (31), avec des guidages longitudinaux (9) arrangés dans la bordure (2) du cadre de brasage (1) et au moins une traverse déplaçable (10; 11, 23) est guidée dans ces guidages longitudinaux (9) et peut être fixée à l'aide d'un organe de fixation (14), de façon à recevoir des plaquettes (31) de différentes dimensions, auquel cas la bordure (2) sur le côté intérieur présente un support (18) pour l'appui de la plaquette (31) qui présente au moins partiellement un bord (3, 4) étagé vers le bas et avec au moins un organe de retenue (16), **caractérisée par le fait qu'**au moins deux recouvrements (232, 234), déplaçables le long d'une des traverses (9, 10, 11, 23), sont disponibles pour recouvrir un écart entre une platine insérée pour le brasage et la traverse déplaçable (10,11,23), lesquelles sont développée au moins partiellement comme support, auquel cas un des deux recouvrements au moins peut être poussée au moins partiellement sous les autres.

2. Masque de brasage selon la revendication 1, **caractérisée par le fait qu'**il comprend des éléments du masque de brasage (40) qui présentent chacun au moins une surface de recouvrement (41) pour la disposition au dessous d'une platine à braser et que des éléments de fixation (50, 51, 52) sont disponibles pour fixer les éléments du masque de brasage (40) au support (18) ou aux traverses (9, 10, 11, 23).

3. Masque de brasage selon la revendication 2, **caractérisée par le fait que** l'élément du masque de brasage (40) présente un crampon (43) pour le serrage partiel d'un support (18).

4. Masque de brasage selon la revendication 3, **caractérisée par le fait que** le crampon (43) présente une tenon (42) qui s'insère dans une rainure (50) dans le support (18) en tant que moyen de fixation.

5. Masque de brasage selon la revendication 2, **caractérisée par le fait que** l'élément du masque de brasage (40) présente une console (45) comme élément de fixation (52) qui peut être fixée à une des traverses (9, 10, 11, 23).

6. Masque de brasage selon la revendication 5, **caractérisée par le fait que** la console (45) peut être fixée à une des traverses (9, 10, 11, 23) à l'aide d'un organe d'arrêt (53).

7. Masque de brasage selon la revendication 2, **caractérisée par le fait que** l'élément du masque de brasage (40) est attaché à une barre d'appui (54) et que la barre d'appui (54) est attachée au moins à un élément de fixation (51) lequel peut être fixé à une des traverses (9,10, 11, 23) à l'aide d'un organe d'arrêt (53).

8. Masque de brasage selon la revendication 7, **caractérisée par le fait que** la barre d'appui (54) peut être fixée à deux éléments de fixation (51) opposés et ainsi à deux traverses (9, 10, 11, 23) opposées l'une à l'autre.

9. Masque de brasage selon la revendication 7, **caractérisée par le fait que** la barre d'appui (54) est utilisable comme appui de base pour des platines rayées.

10. Masque de brasage selon la revendication 7, **caractérisée par le fait que** la barre d'appui (54) contient du titane.
